# EUROPÄISCHE PATENTSCHRIFT

(11) **EP 2 443 274 B1**
(45) Veröffentlichungstag und Bekanntmachung des Hinweises auf die Patenterteilung: **20.03.2019**
(21) Anmeldenummer: 10722124.4
(22) Anmeldetag: 08.06.2010
(51) Int. Cl.: C30B 25/08, C30B 35/00, C23C 16/44, C23C 16/52

(54) **VERFAHREN ZUM EINRICHTEN EINES EPITAXIE-REAKTORS**
METHOD FOR EQUIPPING AN EPITAXY REACTOR
PROCÉDÉ PERMETTANT L'AMÉNAGEMENT D'UN RÉACTEUR D'ÉPITAXIE

(30) Priorität: 15.06.2009 DE 102009025971
(43) Veröffentlichungstag der Anmeldung: 25.04.2012
(73) Patentinhaber: Aixtron SE, 52134 Herzogenrath (DE)
(72) Erfinder: STRAUCH, Gerhard Karl, 52072 Aachen (DE)
(74) Vertreter: Müller, Enno
(86) Internationale Anmeldenummer: PCT/EP2010/057976
(87) Internationale Veröffentlichungsnummer: WO 2010/145969

(56) Entgegenhaltungen:
- WO-A1-2007/060143
- DE-A1-102004 035 335
- DE-A1-102005 055 093
- US-A- 5 863 602
- US-B1- 6 777 347

## Beschreibung

Die Erfindung betrifft ein Verfahren zur Einrichtung einer Prozesskammer in einer Vorrichtung zum Abscheiden mindestens einer Schicht auf einem von einem Suszeptor in der Prozesskammer gehaltenen Substrats, indem durch ein Gaseinlassorgan, insbesondere mit Hilfe eines Trägergases Prozessgase in die Prozesskammer eingeleitet werden, die sich darin insbesondere an heißen Oberflächen in Zerlegungsprodukte zerlegen, welche Zerlegungsprodukte die Schicht bildende Komponenten aufweisen.

Die Erfindung betrifft eine Vorrichtung zum Abscheiden von Schichten auf einem von einem Suszeptor gehaltenen Substrat, in dem durch ein Gaseinlassorgan insbesondere mit Hilfe eines Trägergases Prozessgase in die Prozesskammer eingeleitet werden, die sich darin insbesondere an heißen Oberflächen in Zerlegungsprodukte zerlegen, welche Zerlegungsprodukte die Schicht bildende Komponenten aufweisen.

Aus der DE 689 08 927 T2 ist ein Epitaxie-Reaktor bekannt, der eine im Grundriss kreisrunde, flachzylindrische Prozesskammer aufweist. Die Decke der Prozesskammer wird von einer Deckenplatte gebildet, in deren Zentrum sich ein Gaseinlassorgan befindet, durch welches Prozessgase in die Prozesskammer eingeleitet werden. Der Boden der Prozesskammer, der den Suszeptor ausbildet, trägt eine Vielzahl von Substraten. Die Substrate liegen jeweils auf drehangetriebenen Substrathaltern auf. Der Suszeptor wird von unten beheizt. Dies kann über eine Widerstandsheizung oder über eine RF-Heizung erfolgen.

Die DE 10 2004 035 335 A1 beschreibt ein Verfahren zum Abscheiden glaskeramischer Schichten, wobei ein Reaktor verwendet wird, dessen Wände mit demselben Material wie die aufzubringende Schicht beschichtet sind.

Die US 5,863,602 beschreibt ein Verfahren zum Abscheiden von Siliciumschichten und schlägt vor, dass die Prozesskammerwände durch ein vorheriges Abscheiden von Silicium passiviert werden, um ein Abdampfen von Wasser oder Sauerstoff zu vermeiden.

In der Prozesskammer findet ein MOCVD-Prozess statt. Hierzu werden mit einem Trägergas, bspw. Wasserstoff, metallorganische Verbindungen der III. Hauptgruppe, bspw. TMGa oder TMIn in die Prozesskammer eingeleitet. Als Reaktionspartner zu diesem ersten Prozessgas wird ein zweites Prozessgas in Form eines Hydrids in die Prozesskammer eingeleitet. Es kann sich dabei um AsH₃, PH₃ oder NH₃ handeln.

Auf dem auf den von unten erhitzten Suszeptor aufliegenden Substraten, bspw. GaAs, GaN, InP oder Mischkristalle, wird an eine aus Elementen der III- und V-Hauptgruppe bestehende Schicht abgeschieden. Die in die Prozesskammer eingeleiteten Prozessgase zerlegen sich an den heißen Oberflächen pyrolytisch. Dieses, auf einer pyrolytischen Vorzerlegung beruhende Schichtwachstum findet naturgemäß nicht nur auf den Substratoberflächen, sondern auch auf den die Substrate umgebenden Flächen des Suszeptors statt. Da die dem Suszeptor gegenüberliegende Decke der Prozesskammer durch die vom Suszeptor ausgesandte Wärmestrahlung ebenfalls beheizt wird und nicht in genügendem Maße gekühlt werden kann, findet auch dort ein parasitäres Wachstum statt. Auf Wandungen der Prozesskammer abgeschiedene Beschichtungen sind grundsätzlich unerwünscht.

Bei der gattungsgemäßen Vorrichtung wird nach dem Abscheiden einer dünnen Halbleiterschicht die Prozesskammerdecke durch Ätzen, das "in situ" erfolgen kann, die Belegung an der Prozesskammerdecke und auf dem Suszeptor wieder entfernt. Beim Abscheiden lediglich dünner Schichten werden naturgemäß nur sehr dünne auf das parasitäre Wachstum zurückzuführende Beschichtungen an den Prozesskammerwänden beobachtet. Ihr Einfluss auf die Schichtqualität ist hinnehmbar. Werden in einer gattungsgemäßen Vorrichtung dicke und insbesondere Mehrschichtstrukturen abgeschieden, so bilden sich an den Prozesskammerwänden dicke Beschichtungen. Es wurde beobachtet, dass es beim Abscheiden dicker, insbesondere Mehrschichtstrukturen zu nicht reproduzierbaren Ergebnissen hinsichtlich der Schichtqualität kommt.

Der Erfindung liegt die Aufgabe zugrunde, die bekannte Vorrichtung derart zu ertüchtigen, dass dicke Mehrschichtstrukturen in unmittelbar aufeinander folgenden Prozessschritten reproduzierbar abgeschieden werden können und insbesondere Maßnahmen anzugeben, mit denen verhindert wird, dass sich die Temperaturverteilung innerhalb der Prozesskammer während dieser Prozessschritte ändert.

Gelöst wird die Aufgabe durch das im Anspruch 1 angegebene Verfahren zum Einrichten einer Prozesskammer und durch die im Anspruch 6 angegebene derart eingerichtete Prozesskammer.

Die Erfindung basiert auf der Erkenntnis, dass das Schichtwachstum und insbesondere die Qualität der auf den Substraten abgeschiedenen Halbleiterschichten nicht nur von der Oberflächenkinetik, sondern auch von der Gasphasenkinetik abhängt. Entscheidend für die Schichtqualität ist also nicht nur der eigentliche, möglichst auf die Substratoberfläche beschränkte pyrolytische Zerlegungsprozess. Wesentlich sind vielmehr Vorzerlegungsprozesse und daraus folgende Nukleationen und Adduktbildungen, die in der Gasphase oberhalb des Substrates stattfinden. Durch Kühlung der dem Suszeptor gegenüberliegenden Prozesskammerdecke soll die Temperaturverteilung innerhalb der Prozesskammer eingestellt werden. Letztere ist von erheblicher Bedeutung für die Vorzerlegung der in die Prozesskammer eingeleiteten Precurser. Untersuchungen und Modellrechnungen haben gezeigt, dass die Temperaturverteilung innerhalb der Prozesskammer und insbesondere auf dem Suszeptor nicht nur von der Leistung der den Suszeptor beheizenden Heizung abhängt, sondern auch von den Strahlungsverlusten bzw. von den Strahlungseigenschaften der Wände, die die Prozesskammer bilden. Es wurde gefunden, dass die optischen Eigenschaften: Reflektionsgrad, Absorptionsgrad und Transmissionsgrad der Oberflächen der Prozesskammerwände von entscheidender Bedeutung sind. Erfindungsgemäß sollen diese optischen Eigenschaften der Prozesskammerwände und insbesondere der dem Suszeptor gegenüberliegenden Prozesskammerdecke sollen mit denjenigen übereinstimmen, die die abzuscheidende Schicht besitzt. Bei der bekannten Vorrichtung beobachtete fehlende Reproduzierbarkeit bei der Abscheidung von dicken Schichten wird nämlich darauf zurückgeführt, dass sich bei längeren Wachstumszeiten die optischen Eigenschaften der Prozesskammerdecke ändern. Dies hat zur Folge, dass sich die von der Prozesskammerdecke adsorbierte Wärme während des Prozesses vermindert oder vergrößert und sich dadurch die Temperatur der Prozesskammerdecke ändert, was einen Einfluss auf den Temperaturverlauf innerhalb der gesamten Prozesskammer hat und damit auch einen Einfluss auf das Zerlegungs- und insbesondere Vorzerlegungsverhalten der Prozessgase. Ändert sich der Reflektionsgrad, so hat dies zur Folge, dass eine geringe oder eine höhere Strahlungsleistung von der Prozesskammerdecke zum Suszeptor reflektiert wird. Dies hat nicht nur zur Folge, dass sich die Temperaturverteilung innerhalb der Prozesskammer ändert. Die Änderung der optischen Eigenschaften führt auch dazu, dass die Oberflächentemperatur des Suszeptors und insbesondere die Oberflächentemperatur des Substrates während der Prozessdauer stetig ansteigt bzw. stetig absinkt, bis die Prozesskammerdecke gleichmäßig mit den Zerlegungsprodukten der Prozessgase beschichtet ist. Dies ist etwa dann der Fall, wenn die Schichtdicke dicker ist, als die zweifache optische Dicke, die einem Viertel der Wellenlänge der Frequenz des Strahlungsmaximums bei der Prozesstemperatur entspricht. Erfindungsgemäß wird vorgeschlagen, zumindest der Prozesskammerdecke von vorneherein optische Eigenschaften zu geben, die denjenigen entsprechen, die die abzuscheidende Schicht bzw. die sich an der Prozesskammer aufgrund parasitären Wachstums bildenden Beschichtung besitzt. Relevant sind hier die optischen Eigenschaften in dem Frequenzbereich, in welchem bei den Prozesstemperaturen das Frequenzmaximum liegt (PLANCKsches Strahlungsgesetz bzw. WIENsches Verschiebungsgesetz). Die Wachstumstemperaturen liegen im Bereich von 500 und 1.000°C.

Ein Epitaxie-Reaktor gemäß Stand der Technik, dessen ringförmige Seitenwand und dessen dem Suszeptor gegenüberliegende Decke bspw. aus Edelstahl oder Aluminium besteht, kann zufolge der Erfindung in einfacher Weise nachgerüstet werden. Die Seitenwände bzw. die Decke werden mit insbesondere austauschbaren Verkleidungsstücken versehen. Diese Verkleidungsstücke sind aus einem Material gefertigt, welches im Wesentlichen dieselben oder zumindest ähnlichen optischen Eigenschaften aufweist, wie die abzuscheidende Schicht. Je nachdem, welches Material innerhalb der Prozesskammer abgeschieden werden soll, können hinsichtlich ihrer optischen Eigenschaften an die abzuscheidenden Schichten angepasste Prozesskammerwände verwendet werden. Wenn die abzuscheidenden Halbleiterschichten hochreflektieren und kaum transparent sind, haben auch die in Frage kommenden Verkleidungsstücke eine nahezu spiegelnde Oberfläche und sind nicht transparent. Sind die abzuscheidenden Schichten weniger transparent, sind es auch die Verkleidungsstücke. Typische Werte liegen bei: Transmissionsgrad T ∼ 0; Absorptionsgrad A ∼ 0,8; Reflektionsgrad R = 1 - A.

Es ist nicht erforderlich, dass die Oberfläche der Prozesskammerwandung und insbesondere die Oberfläche der Prozesskammerdecke aus dem identischen Material besteht, aus welchem die in dem jeweiligen Prozess abzuscheidende Schicht besteht. Erfindungsgemäß soll eine Wand derart konstruiert sein, dass sie den optischen Eigenschaften der III-, V-Halbleiterschicht im Bereich der Prozesstemperatur sehr ähnlich ist, wobei R + A + T = 1. Hierdurch ändert sich während einer Belegung der Prozesskammerwände die thermische Wechselwirkung mit der Prozesskammer nicht.

Mit dem erfindungsgemäßen Verfahren können auch mehrere, lang andauernde Abscheidungsprozesse hintereinander durchgeführt werden, ohne dass zwischen den einzelnen Prozessen, also beim Austauschen der Substrate, auch die Prozesskammer gereinigt werden müsste.

## Patentansprüche

1. Verfahren zur Einrichtung einer Prozesskammer in einer Vorrichtung zum Abscheiden mindestens einer III-V-Schicht auf einem von einem Suszeptor in der Prozesskammer gehaltenen Substrats, indem durch ein Gaseinlassorgan, insbesondere mit Hilfe eines Trägergases Prozessgase bestehend aus einem Hydrid der V. Hauptgruppe und einer metallorganischen Verbindung der III. Hauptgruppe in die Prozesskammer eingeleitet werden, die sich darin insbesondere an heißen Oberflächen in Zerlegungsprodukte zerlegen, welche Zerlegungsprodukte die III-V-Schicht bildende Komponenten aufweisen, **dadurch gekennzeichnet, dass** für die zur Prozesskammer weisenden Oberfläche zumindest der dem Suszeptor gegenüberliegenden Wandung der Prozesskammer ein Werkstoff gewählt wird, dessen optischer Reflektionsgrad, optischer Absorptionsgrad und optischer Transmissionsgrad jeweils dem der Schicht entspricht, wobei die Oberfläche aus einem Material besteht, dass nicht mit dem Material der Schicht identisch ist.

2. Verfahren nach Anspruch 1, **dadurch gekennzeichnet, dass** auch die Oberfläche des Suszeptors und/oder der Seitenwände optische Eigenschaften aufweisen, die denen der beim Schichtwachstum abgeschiedenen Beschichtung entsprechen.

3. Verfahren nach einem der vorhergehenden Ansprüche, **dadurch gekennzeichnet, dass** der Suszeptor der Boden einer Prozesskammer ist und das Einlassorgan im Zentrum einer Prozesskammerdecke angeordnet ist.

4. Verfahren nach einem der vorhergehenden Ansprüche, **dadurch gekennzeichnet, dass** die Prozesskammer in Horizontalrichtung vom Trägergas und dem Prozessgas durchströmt wird.

5. Verfahren nach einem der vorhergehenden Ansprüche, **dadurch gekennzeichnet, dass** die an die optischen Eigenschaften der abzuscheidenden Schicht angepassten Prozesskammerwände austauschbare Verkleidungsstücke sind.

6. Vorrichtung zum Abscheiden mindestens einer III-V-Schicht auf einem von einem Suszeptor gehaltenen Substrat, indem durch ein Gaseinlassorgan insbesondere mit Hilfe eines Trägergases Prozessgase bestehend aus einem Hydrid der V. Hauptgruppe und einer metallorganischen Verbindung der III. Hauptgruppe in die Prozesskammer eingeleitet werden, die sich darin insbesondere an heißen Oberflächen in Zerlegungsprodukte zerlegen, welche Zerlegungsprodukte die III-V-Schicht bildende Komponenten aufweisen, **dadurch gekennzeichnet, dass** zumindest die dem Suszeptor gegenüberliegende Wandung der Prozesskammer von einem austauschbaren Verkleidungsstück ausgebildet wird, das an seiner zur Prozesskammer hinweisenden Oberfläche einen optischen Reflektionsgrad, einen optischen Absorptionsgrad und einen optischen Transmissionsgrad aufweist, der jeweils dem der in der Prozesskammer abzuscheidenden Schicht entspricht, wobei die Oberfläche aus einem Material besteht, dass nicht mit dem Material der Schicht identisch ist.

7. Vorrichtung nach Anspruch 6, **dadurch gekennzeichnet, dass** die zur Prozesskammer weisende Oberfläche des Suszeptors und/oder die zur Prozesskammer weisenden Seitenwandungen von Verkleidungsstücken gebildet sind, deren zur Prozesskammer weisenden Oberflächen optische Eigenschaften besitzen, die denjenigen der abzuscheidenden Schicht entsprechen.

## Claims

1. Method for equipping a process chamber in an apparatus for depositing at least one III-V-layer on a substrate held by a susceptor in the process chamber, process gases being introduced into the process chamber through a gas inlet element, in particular by means of a carrier gas, the process gases consisting of a hydride of the V. main group and an organometallic compound of the III. main group decomposing into decomposition products in the process chamber, in particular on hot surfaces, the decomposition products comprising the components that form the III-V-layer, **characterized in that** a material is selected for the surface facing the process chamber at least of the wall of the process chamber that is opposite the susceptor, the optical reflectivity, optical absorptivity and optical transmissivity of which respectively correspond to those of the layer, whereby the surface is made of a material that is not identical to the material of the layer.

2. Method according to Claim 1, **characterized in that** the surface of the susceptor and/or of the side wall also have optical properties that correspond to those of the layer deposited during the layer growth.

3. Method according to one of the preceding claims, **characterized in that** the susceptor is the base of a process chamber and the inlet element is disposed in the center of a process chamber cover.

4. Method according to one of the preceding claims, **characterized in that** flow of the carrier gas and the process gas through the process chamber takes place in the horizontal direction.

5. Method according to one of the preceding claims, **characterized in that** process chamber walls that are matched to the optical properties of the layer to be deposited are exchangeable cladding pieces.

6. Apparatus for depositing a III-V-layer on a substrate held by a susceptor, in which process gases are introduced into the process chamber through a gas inlet element, in particular by means of a carrier gas, the process gases consisting of a hydride of the V. main group and an organometallic compound of the III. main group decomposing into decomposition products in the process chamber, in particular on hot surfaces, the decomposition products comprising the components that form the III-V-layer, **characterized in that** at least the wall of the process chamber opposite the susceptor is formed by an exchangeable cladding piece that has on its surface facing the process chamber an optical reflectivity, an optical absorptivity and an optical transmissivity which respectively correspond to those of the layer to be deposited in the process chamber, whereby the surface is made of a material that is not identical to the material of the layer.

7. Apparatus according to Claim 6, **characterized in that** the surface of the susceptor facing the process chamber and/or the side walls facing the process chamber are formed by cladding pieces, the surfaces of which facing the process chamber have properties that correspond to those of the layer to be deposited.

## Revendications

1. Procédé pour configurer une chambre de traitement dans un appareil de dépôt d'au moins une couche III-V sur un substrat maintenu par un suscepteur dans la chambre de traitement, dans lequel des gaz de traitement sont introduits dans la chambre de traitement par un élément d'entrée de gaz, en particulier au moyen d'un gaz porteur, les gaz de traitement contenant un hydrure du groupe principal V et un composé organométallique du groupe principal III et se décomposant dans la chambre de traitement en produits de décomposition, en particulier sur des surfaces chaudes, les produits de décomposition comprenant des composants qui forment la couche III-V, **caractérisé en ce que** pour la surface orientée vers la chambre de traitement d'au moins la paroi de la chambre de traitement opposée au suscepteur est choisie une matière dont le degré de réflexion optique, le degré d'absorption optique et le degré de transmission optique correspondent respectivement à ceux de la couche, la surface étant constituée d'un matériau qui n'est pas identique au matériau de la couche.

2. Procédé selon la revendication 1, **caractérisé en ce que** la surface du suscepteur et/ou d'une paroi latérale possèdent également des propriétés optiques qui correspondent à celles du revêtement déposé par croissance de couche.

3. Procédé selon l'une des revendications précédentes, **caractérisé en ce que** le suscepteur est le fond/la base de la chambre de traitement et l'élément d'entrée de gaz est disposé au centre d'un plafond de chambre de traitement.

4. Procédé selon l'une des revendications précédentes, **caractérisé en ce que** le flux de gaz porteur et des gaz de traitement circule à travers la chambre de traitement en direction horizontale.

5. Procédé selon l'une des revendications précédentes, **caractérisé en ce que** les parois de chambre de traitement adaptées aux propriétés optiques de la couche à déposer sont des pièces de revêtement échangeables.

6. Dispositif pour déposer au moins une couche III-V sur un substrat maintenu par un suscepteur, dans lequel des gaz de traitement sont introduits dans la chambre de traitement à travers un élément d'entrée de gaz, en particulier au moyen d'un gaz porteur, les gaz de traitement contenant un hydrure du groupe principal V et un composé organométallique du groupe principal III et se décomposant dans la chambre de traitement en produits de décomposition, en particulier sur des surfaces chaudes, les produits de décomposition comprenant des composants qui forment la couche III-V, **caractérisé en ce qu'**au moins la paroi de la chambre de traitement opposée au suscepteur est formée par une pièce de revêtement échangeable qui présente sur sa surface tournée vers la chambre de traitement un degré de réflexion optique, un degré d'absorption optique et un degré de transmission optique qui correspondent respectivement à ceux de la couche devant être déposée dans la chambre de traitement, la surface étant constituée d'un matériau qui n'est pas identique au matériau de la couche.

7. Appareil selon la revendication 6, **caractérisé en ce que** la surface du suscepteur orientée vers la chambre de traitement et/ou les parois latérales orientées vers la chambre de traitement sont formées par des pièces de revêtement dont les surfaces orientées vers la chambre de traitement présentent des propriétés qui correspondent à celles de la couche III-V à déposer.
